# FASCICULE DE BREVET EUROPEEN

(11) **EP 3 053 201 B1**
(45) Date de publication et mention de la délivrance du brevet: **30.10.2019**
(21) Numéro de dépôt: 14789323.4
(22) Date de dépôt: 30.09.2014
(51) Int. Cl.: H01L 33/18, H01L 33/38, H01L 33/08, H01L 33/24, H01L 33/20, H01L 21/02, H01L 29/06, H01L 33/00, H01L 33/32

(54) **DISPOSITIF OPTOÉLECTRONIQUE À DIODES ÉLECTROLUMINESCENTES**
OPTOELEKTRONISCHE VORRICHTUNG MIT LEUCHTDIODEN
OPTOELECTRONIC DEVICE BASED ON LIGHT-EMITTING DIODES

(30) Priorité: 30.09.2013 FR 1359410
(43) Date de publication de la demande: 10.08.2016
(73) Titulaire: Aledia, 38040 Grenoble (FR)
(72) Inventeur: BOUVIER, Christophe, F-38000 Grenoble (FR); DORNEL, Erwan, F-38600 Fontaine (FR)
(74) Mandataire: Cabinet Beaumont
(86) Numéro de dépôt international: PCT/FR2014/052474
(87) Numéro de publication internationale: WO 2015/044622

(56) Documents cités:
- EP-A1- 2 254 164
- WO-A1-2012/075461
- WO-A2-2009/009612
- WO-A2-2012/156620
- DE-A1-102010 012 711
- JP-A- 2007 049 063
- US-A1- 2010 102 380
- US-A1- 2012 061 646
- US-A1- 2012 205 614

## Description

La présente demande de brevet revendique la priorité de la demande de brevet français FR13/59410.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes formées par des éléments tridimensionnels, notamment des microfils ou nanofils semiconducteurs.

### Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI.

Les documents US2012/061646-A2 et WO2012/156620-A2 font partie de l'art antérieur et décrivent des dispositifs électroluminescents à semiconducteur.

Les éléments tridimensionnels, notamment des microfils ou nanofils semiconducteurs, de plusieurs dispositifs optoélectroniques sont généralement formés sur la face avant d'un substrat. Une couche d'un matériau favorisant la croissance des éléments tridimensionnels, appelée couche de germination, peut être interposée entre le substrat et les éléments tridimensionnels.

L'injection de courant dans les éléments tridimensionnels peut être réalisée depuis la face arrière du substrat. Toutefois, le courant doit alors traverser la totalité de l'épaisseur du substrat. Dans le cas d'un substrat semiconducteur, par exemple en silicium, ceci peut se traduire par des pertes par effet Joule importantes. En outre, il peut être difficile d'obtenir une répartition uniforme du courant entre les éléments tridimensionnels.

L'injection de courant dans les éléments tridimensionnels peut être réalisée depuis la face avant du substrat par la couche de germination. Toutefois, pour favoriser la croissance d'éléments tridimensionnels ayant les propriétés cristallographiques souhaitées, il est nécessaire que la couche de germination soit relativement fine. Ceci peut conduire à des pertes par effet Joule importantes et à des difficultés à assurer une répartition uniforme du courant entre les éléments tridimensionnels.

### Résumé

Ainsi, un objet d'un mode de réalisation est de pallier au moins en partie les inconvénients des dispositifs optoélectroniques à diodes électroluminescentes, notamment à microfils ou nanofils, décrits précédemment.

Un autre objet d'un mode de réalisation est de réduire les pertes par effet Joule lors de l'injection de courant dans les diodes électroluminescentes.

Un autre objet d'un mode de réalisation est d'améliorer l'homogénéité de la répartition du courant entre les diodes électroluminescentes.

Ainsi, un mode de réalisation prévoit un dispositif optoélectronique comprenant :
un support comprenant une première face ;
un premier ensemble de premières diodes électroluminescentes comprenant des premiers éléments semiconducteurs filaires, coniques ou tronconiques, en un premier matériau et reposant chacun sur une deuxième face d'un premier plot en un deuxième matériau différent du premier matériau, chaque premier plot comportant, en outre, une troisième face opposée à la deuxième face ; et
une première couche conductrice reliant les premiers plots et s'étendant au moins sur une partie de la deuxième face ou de la troisième face de chaque premier plot, la première couche conductrice et/ou les premiers plots reposant sur le support.

Selon un mode de réalisation, la première couche conductrice est en un troisième matériau différent du premier matériau et du deuxième matériau.

Selon un mode de réalisation, la première couche conductrice est en un matériau choisi parmi le groupe comprenant les alliages comprenant un métal de transition ou plus d'un métal de transition parmi W, Ta, Re, Os, Mo, Nb, Pt, Pd, Cr, Zr, Hf, Cu, Co, Ni et Ti et leurs formes siliciurées, nitrurées et carburées.

Selon un mode de réalisation, la première couche conductrice est en un matériau choisi parmi le groupe comprenant les siliciures et les métaux adaptés à former un siliciure, notamment Pt, PtSi, Ti, TiSi₂, Co, CoSi₂, CoSi, Co₂Si, Ni, NiSi, NiSi₂, W, WSi₂, Mo, MoSi₂, Ta et TaSi₂.

Selon un mode de réalisation, la première couche conductrice est en un matériau choisi parmi le groupe comprenant les siliciures et les métaux adaptés à former un siliciure stable sur du silicium à une température de 1000°C, notamment W, WSi₂, Mo, MoSi₂, Ta et TaSi₂, Ti, TiSi₂, Co, CoSi₂, TiW et TiWSi.

Selon un mode de réalisation, la première couche conductrice est en un matériau choisi parmi les matériaux présentant un coefficient de dilatation thermique proche, à 10 % près, du coefficient de dilatation thermique du silicium ou du silicium polycristallin, notamment W, WSi₂, TiW, TiWSi₂.

Selon un mode de réalisation, les premiers plots reposent sur le support et la première couche conductrice s'étend sur le support entre les premiers plots et recouvre une partie de la deuxième face de chaque premier plot, la première couche conductrice étant ouverte aux emplacements de chaque premier élément semiconducteur.

Selon un mode de réalisation, le dispositif comprend, en outre, une première couche isolante recouvrant au moins en partie la première couche conductrice.

Selon un mode de réalisation, la première couche isolante s'étend entre les premiers éléments semiconducteurs et la première couche conductrice.

Selon un mode de réalisation, la première couche conductrice est au contact des premiers éléments semiconducteurs.

Selon un mode de réalisation, le support comprend un substrat semiconducteur et une région isolante entre le substrat et la première couche conductrice.

Selon un mode de réalisation, la première couche conductrice repose sur la première face et chaque premier plot repose sur la première couche conductrice du côté de la troisième face.

Selon un mode de réalisation, une deuxième couche isolante recouvre la première couche conductrice et une partie de chaque premier plot.

Selon un mode de réalisation, la partie de la première couche conductrice non recouverte par les premiers plots est nitrurée en surface.

Selon un mode de réalisation, chaque premier plot est en un matériau choisi parmi le groupe comprenant un nitrure, un carbure ou un borure d'un métal de transition de la colonne IV, V ou VI du tableau périodique des éléments ou une combinaison de ces composés.

Selon un mode de réalisation, le support est un substrat semiconducteur non dopé ou dopé avec une concentration de dopants inférieure ou égale à 5^{∗}10¹⁶ atomes/cm³, le dispositif comprenant, en outre, une région semiconductrice dopée s'étendant dans le substrat depuis la première face avec une concentration de dopants comprise entre 5^{∗}10¹⁶ atomes/cm³ et 2^{∗}10²⁰ atomes/cm³, ladite région étant au contact de la première couche conductrice.

Selon un mode de réalisation, le dispositif comprenant, en outre :
une première électrode reliée aux premières diodes électroluminescentes ;
un deuxième ensemble de deuxièmes diodes électroluminescentes comprend des deuxièmes éléments semiconducteurs filaires, coniques ou tronconiques reposant chacun sur une quatrième face d'un deuxième plot, chaque deuxième plot comportant, en outre, une cinquième face opposée à la quatrième face ;
une deuxième couche conductrice reliant les deuxièmes plots et s'étendant au moins sur une partie de la quatrième face ou de la cinquième face de chaque deuxième plot, la deuxième couche conductrice et/ou les deuxièmes plots reposant sur le support ; et
une deuxième électrode reliée aux deuxièmes diodes électroluminescentes et venant au contact de la première couche conductrice.

Un mode de réalisation prévoit également un procédé de fabrication d'un dispositif optoélectronique comprenant les étapes suivantes :
prévoir un support comprenant une première face ;
former un premier ensemble de premières diodes électroluminescentes comprenant des premiers éléments semiconducteurs filaires, coniques ou tronconiques reposant chacun sur une deuxième face d'un premier plot, chaque premier plot comportant, en outre, une troisième face opposée à la deuxième face ; et
former une première couche conductrice reliant les premiers plots et s'étendant au moins sur une partie de la deuxième face ou de la troisième face de chaque premier plot, la première couche conductrice et/ou les premiers plots reposant sur le support.

Selon un mode de réalisation, le procédé comprend les étapes successives suivantes :
former les premiers plots sur le support ;
recouvrir les premiers plots et le support d'une troisième couche conductrice ;
former des premières ouvertures dans la troisième couche conductrice pour former la première couche conductrice, chaque première ouverture exposant une première partie de l'un des premiers plots ;
recouvrir la troisième couche conductrice et les premières parties exposées d'une troisième couche isolante ;
former des deuxièmes ouvertures dans la troisième couche isolante, chaque deuxième ouverture exposant une deuxième partie de l'un des premiers plots ; et
faire croître les premiers éléments semiconducteurs depuis les deuxièmes parties exposées des premiers plots.

Selon un mode de réalisation, le procédé comprend les étapes successives suivantes :
former les premiers plots sur le support ;
recouvrir les premiers plots et le support d'une quatrième couche conductrice ;
recouvrir la quatrième couche conductrice d'une quatrième couche isolante ;
former des troisièmes ouvertures dans la quatrième couche isolante et des quatrièmes ouvertures, prolongeant les troisièmes ouvertures, dans la quatrième couche conductrice, pour former la première couche conductrice, chaque quatrième ouverture exposant une troisième partie de l'un des premiers plots ; et
faire croître les premiers éléments semiconducteurs depuis les troisièmes parties exposées des premiers plots.

Selon un mode de réalisation, le procédé comprend les étapes successives suivantes :
recouvrir le support d'une cinquième couche conductrice ;
former les premiers plots sur la cinquième couche conductrice ;
recouvrir la cinquième couche conductrice et les premiers plots d'une cinquième couche isolante ;
former des cinquièmes ouvertures dans la cinquième couche isolante, chaque cinquième ouverture exposant une quatrième partie de l'un des premiers plots ; et
faire croître les premiers éléments semiconducteurs depuis les quatrièmes parties exposées des premiers plots.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B sont des vues en coupe, partielles et schématiques, d'un mode de réalisation d'un dispositif optoélectronique à microfils ou nanofils ;
les figures 2 à 7 sont des vues en coupe, partielles et schématiques, d'autres modes de réalisation d'un dispositif optoélectronique à microfils ou nanofils ;
les figures 8A à 8D sont des coupes, partielles et schématiques, de structures obtenues à des étapes successives d'un mode de réalisation d'un procédé de fabrication du dispositif optoélectronique représenté aux figures 1A et 1B ;
les figures 9A à 9C sont des coupes, partielles et schématiques, de structures obtenues à des étapes successives d'un mode de réalisation d'un procédé de fabrication du dispositif optoélectronique représenté en figure 2 ; et
les figures 10A à 10C sont des coupes, partielles et schématiques, de structures obtenues à des étapes successives d'un mode de réalisation d'un procédé de fabrication du dispositif optoélectronique représenté en figure 5.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente description concerne des dispositifs optoélectroniques à éléments tridimensionnels, par exemple des microfils, des nanofils, des éléments coniques ou des éléments tronconiques. Dans la suite de la description, des modes de réalisation sont décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Selon un mode de réalisation, les éléments tridimensionnels formant les diodes électroluminescentes sont formés sur des plots de germination constitués d'un matériau favorisant la croissance des éléments tridimensionnels. Pour polariser convenablement les diodes électroluminescentes, il est prévu une couche d'un matériau conducteur, éventuellement perforée aux emplacements des éléments tridimensionnels, au contact des plots de germination. Les plots de germination peuvent être disposés sur la couche conductrice ou la couche conductrice peut recouvrir partiellement les plots de germination. Dans tous les cas, il y a un recouvrement au moins partiel entre la face supérieure ou la face inférieure de chaque plot de germination et la couche conductrice.

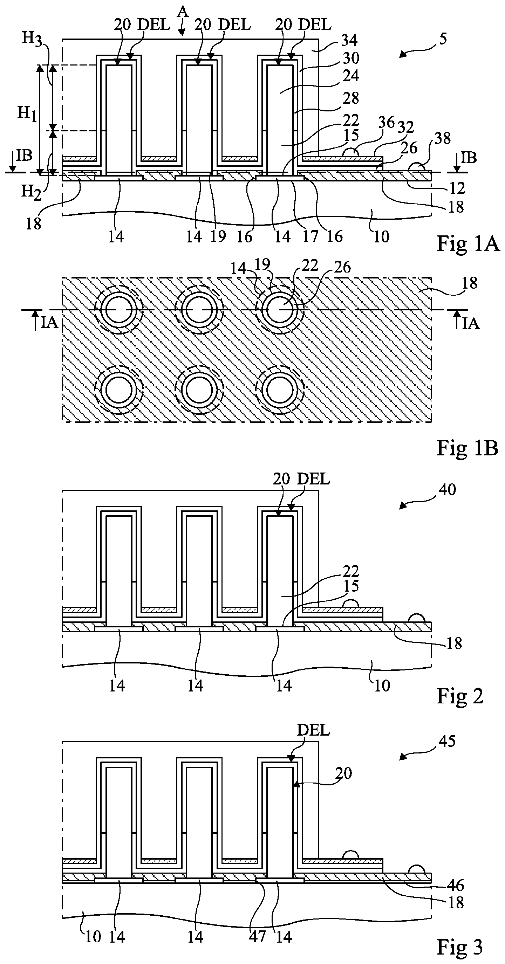

Les figures 1A et 1B sont des vues en coupe, partielles et schématiques, d'un mode de réalisation d'un dispositif optoélectronique 5 réalisé à partir de fils tels que décrits précédemment et adaptés à l'émission d'un rayonnement électromagnétique.

En figure 1A, on a représenté une structure comprenant, du bas vers le haut :
un substrat 10 comprenant une face supérieure 12, de préférence plane au moins au niveau des diodes électroluminescentes ;
des plots de germination 14 favorisant la croissance de fils et disposés sur la face 12, chaque plot de germination 14 comprenant une paroi supérieure 15, des parois latérales 16 et une paroi inférieure 17, la paroi inférieure 17 étant opposée à la paroi supérieure 15 et reposant sur le substrat 10 ;
une couche conductrice 18 s'étendant entre les plots de germination 14 et recouvrant partiellement les parois supérieures 15 des plots de germination 14, la couche conductrice 18 comprenant des ouvertures 19, chaque ouverture exposant une partie de la paroi supérieure 15 de l'un des plots de germination 14 ;
des fils 20 (trois fils étant représentés en figure 1A) de hauteur H₁, chaque fil 20 étant en contact avec la face supérieure 15 de l'un des plots de germination 14, chaque fil 20 comprenant une portion inférieure 22, de hauteur H₂, en contact avec le plot de germination 14 et une portion supérieure 24, de hauteur H₃, prolongeant la portion inférieure 22 ;
une couche isolante 26 s'étendant sur la couche conductrice 18 et sur les flancs latéraux de la portion inférieure 22 de chaque fil 20 ;
une coque 28 comprenant un empilement de couches semiconductrices recouvrant chaque portion supérieure 24 ;
une couche 30 formant une électrode recouvrant chaque coque 28 et s'étendant, en outre, sur la couche isolante 26 ;
une couche conductrice 32 recouvrant la couche d'électrode 30 entre les fils 20 mais ne s'étendant pas sur les fils 20 ;
une couche d'encapsulation 34 recouvrant la partie du dispositif optoélectronique où sont formés les fils 20 ;
un plot 36 d'un matériau conducteur s'étendant sur la couche conductrice 32 ; et
un plot 38 d'un matériau conducteur s'étendant sur la couche conductrice 18.

Le dispositif optoélectronique 5 peut, en outre, comprendre une couche de luminophores, non représentée, prévue sur la couche d'encapsulation 34 ou confondue avec celle-ci.

L'ensemble formé par chaque fil 20, le plot de germination 14 et la coque 28 associés constitue une diode électroluminescente DEL. La base de la diode DEL correspond au plot de germination 14. Les diodes électroluminescentes DEL sont connectées en parallèle et forment un ensemble A de diodes électroluminescentes. L'ensemble A peut comprendre de quelques diodes électroluminescentes DEL à un millier de diodes électroluminescentes DEL.

Le substrat 10 peut correspondre à une structure monobloc ou correspondre à une couche recouvrant un support constitué d'un autre matériau. Le substrat est, par exemple, un substrat semiconducteur, tel qu'un substrat en silicium, en germanium, en carbure de silicium, en un composé III-V, tel que du GaN ou du GaAs, ou un substrat en ZnO. Le substrat semiconducteur peut être dopé ou non dopé. Le substrat 10 peut être en un matériau isolant, par exemple en saphir, en verre ou en céramique. De préférence, le substrat est en silicium, notamment en silicium monocristallin ou polycristallin.

De préférence, le substrat 10 est un substrat semiconducteur non dopé ou faiblement dopé avec une concentration de dopants inférieure ou égale à 5^{∗}10¹⁶ atomes/cm³, de préférence sensiblement égale à 10¹⁵ atomes/cm³. Le substrat 10 a une épaisseur comprise entre 275 µm et 1500 µm, de préférence 725 µm. Le substrat 10 peut correspondre à une structure multicouches de type silicium sur isolant, également appelée SOI (acronyme anglais pour Silicon On Insulator).

Dans le cas d'un substrat 10 de silicium, des exemples de dopants de type P sont le bore (B) ou l'indium (In) et des exemples de dopants de type N sont le phosphore (P), l'arsenic (As), ou l'antimoine (Sb). De préférence, le substrat 10 est dopé de type P au Bore.

La face 12 du substrat 10 de silicium peut être une face (100) .

Les plots de germination 14, appelés également îlots de germination, sont en un matériau favorisant la croissance des fils 20. A titre d'exemple, le matériau composant les plots de germination 14 peut être un nitrure, un carbure ou un borure d'un métal de transition de la colonne IV, V ou VI du tableau périodique des éléments ou une combinaison de ces composés. A titre d'exemple, les plots de germination 14 peuvent être en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci. Les plots de germination 14 peuvent être dopés du même type de conductivité que le substrat 10.

L'épaisseur de chaque plot de germination 14 est comprise entre 5 nm et 100 nm, de préférence 25 nm.

Le matériau conducteur formant la couche conductrice 18 est choisi parmi le groupe des métaux de transition, notamment les matériaux et alliages comprenant les éléments W, Ta, Re, Os, Mo, Nb, Pt, Pd, Cr, Zr, Hf, Cu, Co, Ni et Ti incluant leurs formes siliciurées, nitrurées ou carburées ; de préférence parmi les siliciures et métaux pouvant former un siliciure notamment Pt, PtSi, Ti, TiSi₂, Co, CoSi₂, CoSi, Co₂Si, Ni, NiSi, NiSi₂, W, WSi₂, Mo, MoSi₂, Ta et TaSi₂ ; plus préférentiellement parmi les siliciures et métaux pouvant former un siliciure stable sur du silicium à une température de 1000°C notamment W, WSi₂, Mo, MoSi₂, Ta, TaSi₂, Ti, TiSi₂, Co, CoSi₂, TiW, TiWSi ; encore plus préférentiellement parmi les siliciures et métaux pouvant former un siliciure présentant un coefficient de dilatation thermique égal, à 10 % près, au coefficient de dilatation thermique du silicium ou du silicium polycristallin notamment W, WSi₂, TiW, TiWSi₂. Avantageusement, le matériau peut être choisi de manière à ce qu'il forme un siliciure en contact avec le substrat silicium. Par exemple, le matériau déposé pour former la couche conductrice peut être du W, Ti, TiW, Co ou Ni qui par la suite du procédé de fabrication forme partiellement un siliciure. Ainsi le contact mécanique et électrique est avantageusement amélioré.

De préférence, le matériau conducteur formant la couche conductrice est le tungstène (W). La résistivité électrique du matériau conducteur est inférieure à 10 pohm.cm à 300 K. L'épaisseur de la couche conductrice 18 est comprise entre 50 nm et 1000 nm, de préférence 300 nm.

La forme des ouvertures 19 présentes dans la couche conductrice 18 peut être adaptée à la section souhaitée des fils 20. A titre d'exemple, comme cela est représenté en figure 1B, les ouvertures 19 ont une forme circulaire. A titre de variante, les ouvertures 19 peuvent avoir une forme ovale ou polygonale, notamment triangulaire, rectangulaire, carrée ou hexagonale. En figure 1B, on a représenté le contour des plots de germination 14 par une ligne en traits pointillés de forme circulaire. Toutefois, les plots de germination 14 peuvent avoir une forme différente, notamment ovale ou polygonale, notamment triangulaire, rectangulaire, carrée ou hexagonale.

La couche isolante 26 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), en oxyde d'hafnium (HfO₂) ou en diamant. A titre d'exemple, l'épaisseur de la couche isolante 26 est comprise entre 5 nm et 800 nm, par exemple égale à environ 30 nm. Dans le présent mode de réalisation, la couche isolante 26 s'étend notamment dans chaque ouverture 19 de la couche conductrice 18 jusqu'à la paroi supérieure 15 du plot de germination 14 correspondant, entre la couche conductrice 18 et le fil 20.

Les fils 20 sont, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 20 peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 20 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 20 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 20 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 20 peut être compris entre 50 nm et 2,5 µm. La hauteur H₁ de chaque fil 20 peut être comprise entre 250 nm et 50 µm. Chaque fil 20 peut avoir une structure semiconductrice allongée selon un axe sensiblement perpendiculaire à la face 12. Chaque fil 20 peut avoir une forme générale cylindrique. Les axes de deux fils 20 adjacents peuvent être distants de 0,5 µm à 20 µm et de préférence de 2,5 µm à 6 µm. A titre d'exemple, les fils 20 peuvent être régulièrement répartis comme cela est représenté en figure 1B. A titre d'exemple, les fils 20 peuvent être également répartis régulièrement selon un réseau hexagonal.

A titre d'exemple, la portion inférieure 22 de chaque fil 20 est principalement constituée du composé III-N, par exemple du nitrure de gallium, pouvant être dopé du même type que le substrat 10, par exemple de type N, par exemple au silicium. La portion inférieure 22 s'étend sur une hauteur H₂ qui peut être comprise entre 100 nm et 25 µm.

A titre d'exemple, la portion supérieure 24 de chaque fil 20 est au moins partiellement réalisée dans un composé III-N, par exemple du GaN. La portion supérieure 24 peut être dopée de type N, éventuellement moins fortement dopée que la portion inférieure 22, ou ne pas être intentionnellement dopée. La portion supérieure 24 s'étend sur une hauteur H₃ qui peut être comprise entre 100 nm et 25 µm.

La coque 28 peut comprendre un empilement de plusieurs couches comprenant notamment :
- une couche active recouvrant la portion supérieure 24 du fil 20 associé ;
- une couche intermédiaire de type de conductivité opposé à la portion inférieure 22 recouvrant la couche active ; et
- une couche de liaison recouvrant la couche intermédiaire et recouverte par l'électrode 30.

La couche active est la couche depuis laquelle est émise la majorité du rayonnement fourni par la diode électroluminescente DEL. Selon un exemple, la couche active peut comporter des moyens de confinement, tels que des puits quantiques multiples. Elle est, par exemple, constituée d'une alternance de couches de GaN et de InGaN ayant des épaisseurs respectives de 3 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure 24 de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 30. A titre d'exemple, la couche de liaison peut être dopée très fortement du type opposé à la portion inférieure 22 de chaque fil 20, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 30 est adaptée à polariser la couche active de chaque fil 20 et à laisser passer le rayonnement électromagnétique émis par les diodes électroluminescentes DEL. Le matériau formant l'électrode 30 peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 30 a une épaisseur comprise entre 5 nm et 200 nm, de préférence entre 20 nm et 50 nm.

La couche conductrice 32 correspond, de préférence à une couche métallique, par exemple en aluminium, en argent, en cuivre ou en zinc. A titre d'exemple, la couche conductrice 32 a une épaisseur comprise entre 20 nm et 300 nm, de préférence entre 100 nm et 200 nm.

La couche d'encapsulation 34 est réalisée en un matériau isolant au moins partiellement transparent. L'épaisseur minimale de la couche d'encapsulation 34 est comprise entre 250 nm et 50 µm de sorte que la couche d'encapsulation 34 recouvre complètement l'électrode 30 au sommet des diodes électroluminescentes DEL. La couche d'encapsulation 34 peut être réalisée en un matériau inorganique au moins partiellement transparent. Selon un exemple, la couche d'encapsulation 34 est en silicone. Selon un autre exemple, le matériau inorganique est choisi parmi le groupe comprenant les oxydes de silicium du type SiOₓ où x est un nombre réel compris entre 0 et 2, ou SiO_{y}N_{z} où y est un nombre réel compris entre 0 et 2 et z est compris entre 0 et 0,57 et les oxydes d'aluminium, par exemple Al₂O₃. La couche d'encapsulation 34 peut être réalisée en un matériau organique au moins partiellement transparent. A titre d'exemple, la couche d'encapsulation 34 est un polymère époxyde.

Les plots conducteurs 36, 38 sont adaptés au type de procédé utilisé pour connecter le dispositif optoélectronique 5 à un autre circuit, par exemple un circuit imprimé sur lequel le dispositif optoélectronique 5 est fixé. Les méthodes de connexion peuvent comprendre des opérations de soudure de fils (en anglais wire bonding). La soudure de fils peut se faire avec un fil d'or, argent, cuivre ou aluminium.

La polarisation de chaque diode électroluminescente DEL de l'ensemble A est obtenue en reliant le plot conducteur 36 à une source d'un premier potentiel de référence et en reliant le plot conducteur 38 à une source d'un deuxième potentiel de référence. A titre d'exemple, dans le cas de fil 20 dopé de type N, le premier potentiel de référence peut être supérieur au deuxième potentiel de référence et la source du deuxième potentiel de référence peut correspondre à la masse.

La couche conductrice 18 permet le transport de courant avec des pertes par effet Joule réduites. En outre, la couche conductrice 18 permet d'améliorer l'homogénéité du courant traversant chaque diode électroluminescente DEL. Le fait que la couche conductrice 18 recouvre partiellement la paroi supérieure 15 de chaque plot de germination 14 en plus des parois latérales 16 permet avantageusement d'augmenter la surface de contact entre chaque plot de germination 14 et la couche conductrice 18.

La figure 2 est une vue en coupe analogue à la figure 1A d'un autre mode de réalisation d'un dispositif optoélectronique 40. Le dispositif optoélectronique 40 comprend l'ensemble des éléments du dispositif optoélectronique 5 représenté en figure 1A à la différence que la couche conductrice 18 recouvre la paroi supérieure 15 de chaque plot de germination 14 jusqu'à venir au contact de la portion inférieure 22 du fil 20 reposant sur le plot de germination 14. Ceci permet, de façon avantageuse, d'augmenter la surface de contact entre la couche conductrice 18 et la base de chaque diode électroluminescente DEL.

La figure 3 est une vue en coupe analogue à la figure 2 d'un autre mode de réalisation d'un dispositif optoélectronique 45. Le dispositif optoélectronique 45 comprend l'ensemble des éléments du dispositif optoélectronique 40 représenté en figure 2 à la différence qu'une couche isolante 46 est prévue entre le substrat 10 et la couche conductrice 18. La couche isolante 46 comprend des ouvertures 47 aux emplacements des plots de germination 14.

Les matériaux diélectriques décrits précédemment pour réaliser la couche isolante 26 peuvent également être utilisés pour réaliser la couche isolante 46 par exemple SiO₂, SiN ou Si₃N₄. A titre d'exemple, l'épaisseur de la couche isolante 46 est comprise entre 10 nm et 1000 nm, et est par exemple égale à environ 200 nm. La couche isolante 46 permet avantageusement d'isoler la couche conductrice 18 du substrat 10.

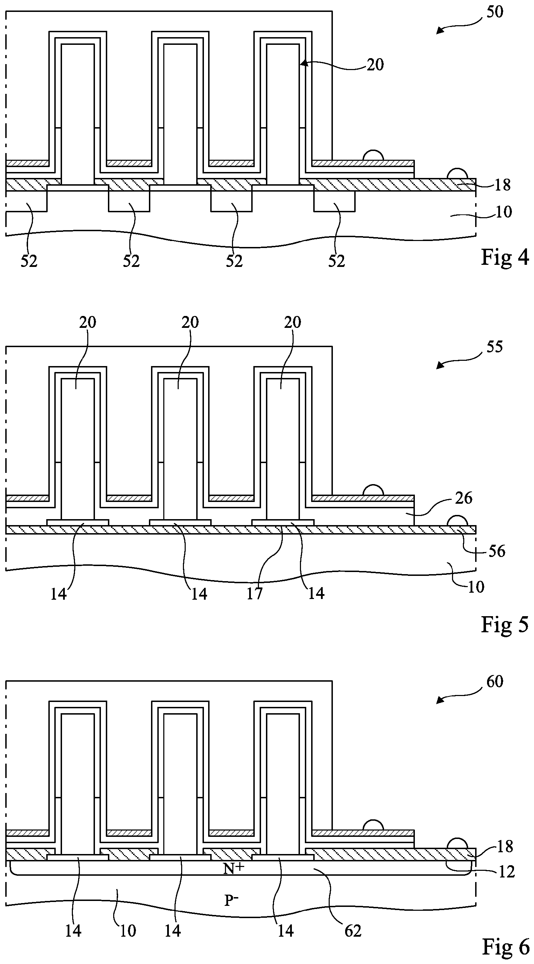

La figure 4 est une vue en coupe analogue à la figure 3 d'un autre mode de réalisation d'un dispositif optoélectronique 50. Le dispositif optoélectronique 50 comprend l'ensemble des éléments du dispositif optoélectronique 45 représenté en figure 3 à la différence que la couche isolante 46 est remplacée par des tranchées isolantes 52 ou STI (acronyme anglais pour Shallow Trench Isolation) s'étendant dans le substrat 10. La profondeur de chaque tranchée isolante 52 dans le substrat 10 est comprise entre 150 nm et 2000 nm.

La figure 5 est une vue en coupe analogue à la figure 1A d'un autre mode de réalisation d'un dispositif optoélectronique 55. Le dispositif optoélectronique 55 comprend l'ensemble des éléments du dispositif optoélectronique 5 représenté en figure 1A à la différence que la couche conductrice 18 est remplacée par une couche conductrice 56 s'étendant sur le substrat 10, les plots de germination 14 reposant sur la couche conductrice 56. La couche conductrice 56 est au contact de la paroi inférieure 17 de chaque plot de germination 14. Les matériaux conducteurs décrits précédemment pour réaliser la couche conductrice 18 peuvent également être utilisés pour réaliser la couche conductrice 56. A titre d'exemple, l'épaisseur de la couche conductrice 56 est comprise entre 50 nm et 1000 nm, et est par exemple égale à environ 300 nm. De préférence, la couche conductrice 56 est sensiblement continue au moins dans la région du dispositif optoélectronique 55 où sont formés les plots de germination 14.

Le fait de réaliser des plots de germination 14 séparés sur la couche conductrice 56 plutôt qu'une couche de germination continue reposant sur la couche conductrice 56 facilite l'obtention des plots de germination ayant les propriétés cristallographiques recherchées pour favoriser la croissance des fils 20.

La figure 6 est une vue en coupe analogue à la figure 1 d'un autre mode de réalisation d'un dispositif optoélectronique 60. Le dispositif optoélectronique 60 comprend l'ensemble des éléments du dispositif optoélectronique 5 représenté en figure 1, le substrat 10 étant un substrat semiconducteur non dopé ou faiblement dopé d'un premier type de conductivité, par exemple de type P, avec une concentration de dopants inférieure ou égale à 5^{∗}10¹⁶ atomes/cm³. Le dispositif optoélectronique 60 comprend, en outre, une région 62 s'étendant dans le substrat semiconducteur 10 depuis la face 12 sous les plots de germination 14 et sous la couche conductrice perforée 18. La région 62 est une région fortement dopée. De préférence, le type de conductivité de la région 62 est opposé au type de conductivité du substrat 10. A titre d'exemple, en figure 6, on a représenté un substrat 10 faiblement dopé de type P et une région 62 fortement dopée de type N. La concentration de dopants de la région 62 est comprise entre 5^{∗}10¹⁶ atomes/cm³ et 2^{∗}10²⁰ atomes/cm³, de préférence entre 1^{∗}10¹⁹ atomes/cm³ et 2^{∗}10²⁰ atomes/cm³. L'épaisseur de la région 62 est comprise entre 150 nm et plusieurs micromètres, de préférence entre 150 nm et 1 µm, plus préférentiellement entre 150 nm et 400 nm.

La région fortement dopée 62 permet de réduire encore davantage les pertes par effet Joule lors de l'injection de courant dans les diodes électroluminescentes DEL.

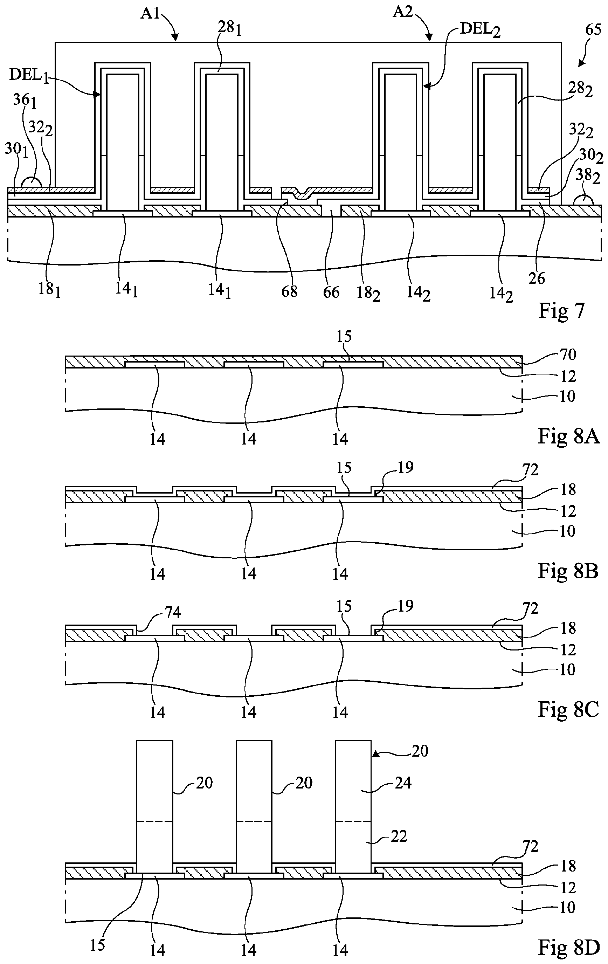

La figure 7 est une vue en coupe d'un dispositif optoélectronique 65 qui comprend deux ensembles A1, A2 de diodes électroluminescentes DEL. Chaque ensemble A1, A2 de diodes électroluminescentes peut avoir la même structure que celle de l'ensemble A représenté en figure 1A. En figure 7, pour les éléments communs aux ensembles A1, A2 et A, on ajoute l'indice "1" aux références des éléments associés à l'ensemble A1 et l'indice "2" aux références des éléments associés à l'ensemble A2.

L'ensemble A1 de diodes électroluminescentes est connecté en série avec l'ensemble A2 de diodes électroluminescentes. Dans ce but, la couche conductrice 18₁ associée à l'ensemble A1 de diodes électroluminescentes est séparée d'une distance entre 1 µm et 50 µm, de la couche conductrice 18₂ associée à l'ensemble A2 de diodes électroluminescentes par une portion 66 de la couche isolante 26. En outre, l'électrode 30₂ et la couche conductrice 32₂ de l'ensemble A2 de diodes électroluminescentes DEL₂ s'étendent jusqu'à une ouverture 68 prévue dans la couche isolante 26 pour venir au contact de la couche conductrice 18₁ de l'ensemble A1.

L'électrode 30₁ de l'ensemble A1 de diodes électroluminescentes est reliée à la source du premier potentiel de référence par le plot de contact 36₁ et la couche conductrice 18₂ de l'ensemble A2 de diodes électroluminescentes est reliée à la source du deuxième potentiel de référence par le plot de contact 38₂. La différence entre les premier et deuxième potentiels de référence doit être supérieure à la somme des tensions de seuil de chaque ensemble de diodes afin de polariser les deux ensembles de diodes en série en direct. A titre d'exemple, la différence entre les premier et deuxième potentiels de référence est de l'ordre de 6 V pour deux ensembles de diodes électroluminescentes GaN en série.

En figure 7, on a représenté un dispositif optoélectronique 65 comprenant deux ensembles A1, A2 de diodes électroluminescentes disposés en série. Le nombre d'ensembles de diodes électroluminescentes disposés en série peut être plus important. Le dispositif optoélectronique 65 peut comprendre de 2 à plus de 100 ensembles de diodes électroluminescentes disposés en série. L'association d'ensembles de diodes électroluminescentes montés en série permet d'augmenter l'amplitude maximale de la tension d'alimentation appliquée aux ensembles de diodes électroluminescentes qui est égale à la différence entre les premier et deuxième potentiels de référence. A titre d'exemple, la tension d'alimentation peut avoir une amplitude maximale supérieure ou égale à 6 V, par exemple d'environ 12 V, 24 V, 48 V, 110 V ou 240 V.

La couche active de la coque 28₁ peut être fabriquée de manière identique ou non à la couche active de la coque 28₂. Par exemple, la couche active de la coque 28₁ peut être adaptée pour émettre une lumière bleue et la couche active de la coque 28₂ peut être adaptée pour émettre une lumière verte. Ceci peut être obtenu notamment en adaptant les épaisseurs ou les compositions des puits quantiques composant les couches actives des coques 28₁ et 28₂.

A titre d'exemple, le dispositif optoélectronique 65 peut comporter un troisième ensemble de diodes électroluminescentes connecté en série aux ensembles A1 et A2. A titre d'exemple, cette troisième diode électroluminescente globale peut être adaptée pour émettre une lumière rouge. La composition des lumières bleue, verte, et rouge peut alors être choisie pour que l'oeil humain perçoive une lumière blanche par composition des couleurs.

Les figures 8A à 8D illustrent des étapes d'un mode de réalisation d'un procédé de fabrication du dispositif optoélectronique 5 représenté en figure 1.

La figure 8A représente la structure obtenue après les étapes suivantes :
(1) Formation sur la face 12 du substrat 10 des plots de germination 14.
   Les plots de germination 14 peuvent être obtenus par le dépôt d'une couche de germination sur la face 12 et par la gravure de portions de la couche de germination jusqu'à la face 12 du substrat 10 pour délimiter les plots de germination. La couche de germination peut être déposée par un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Déposition). En outre, des procédés tels l'évaporation ou la pulvérisation cathodique réactive peuvent être utilisés.
   Lorsque les plots de germination 14 sont en nitrure d'aluminium, ils peuvent être sensiblement texturés et posséder une polarité préférentielle. La texturation des plots 14 peut être obtenue par un traitement supplémentaire réalisé après le dépôt de la couche de germination. Il s'agit, par exemple, d'un recuit sous flux d'ammoniac (NH₃).
(2) Dépôt d'une couche conductrice continue 70 recouvrant la face 12 et les plots de germination 14. La couche conductrice continue 70 peut être déposée par un procédé du type PVD ou CVD, de préférence par un procédé de type PVD.
   La figure 8B représente la structure obtenue après les étapes suivantes :
(3) Gravure des ouvertures 19 dans la couche conductrice continue 70 pour exposer une partie de la paroi supérieure 15 de chaque plot de germination 14. La couche conductrice 70 comprenant les ouvertures 19 correspond à la couche conductrice 18 décrite précédemment. La gravure des ouvertures 19 peut être réalisée par gravure sèche, par exemple une gravure au plasma.
(4) Formation d'une couche isolante continue 72 recouvrant la couche conductrice 18 et les plots de germination 14. Le dépôt de la couche isolante continue 72 peut être réalisé par dépôt PECVD, CVD, ou LPCVD.
   La figure 8C représente la structure obtenue après les étapes suivantes :
(5) Gravure d'ouvertures 74 dans la couche isolante continue pour exposer une partie de la paroi supérieure 15 de chaque plot de germination 14. La gravure des ouvertures 72 peut être réalisée par gravure plasma ou par gravure humide.
   La figure 8D représente la structure obtenue après les étapes suivantes :
(6) Croissance de la portion inférieure 22 de chaque fil 20 sur la hauteur H₂ depuis la partie exposée de la paroi supérieure 15 du plot de germination 14 sous-jacent.
(7) Croissance de la portion supérieure 24 de hauteur H₃ de chaque fil 20 sur le sommet de la portion inférieure 22.

Le procédé de croissance des fils 20 peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

A titre d'exemple, le procédé de croissance des fils peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).

Selon un mode de réalisation de l'invention, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).

La présence de silane parmi les gaz précurseurs entraîne l'incorporation de silicium au sein du composé GaN. On obtient ainsi une portion inférieure 22 dopée de type N. En outre, ceci se traduit par la formation d'une couche de nitrure de silicium, non représentée, qui recouvre le pourtour de la portion 22 de hauteur H₂, à l'exception du sommet au fur et à mesure de la croissance de la portion 22.

Pour la croissance de la portion supérieure 24, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion supérieure 24 peut être dopée de type N en raison de la diffusion dans cette portion active de dopants provenant des portions passivées adjacentes ou en raison du dopage résiduel du GaN.

Les étapes ultérieures du procédé de fabrication sont les suivantes :
(8) Formation par épitaxie, pour chaque fil 20, des couches composant la coque 30. Compte tenu de la présence de la couche de nitrure de silicium recouvrant le pourtour de la portion inférieure 22, le dépôt des couches composant la coque 30 ne se produit que sur la portion supérieure 24 du fil 20 non recouverte de la couche de nitrure de silicium.
(9) Formation de la couche isolante 26, par exemple par dépôt conforme d'une couche isolante sur la totalité de la structure obtenue à l'étape (8) et gravure de cette couche pour exposer la portion supérieure 24 de chaque fil 20. Dans le mode de réalisation décrit précédemment, la couche isolante 26 ne recouvre pas la coque 30. A titre de variante, la couche isolante 26 peut recouvrir une partie de coque 30. En outre, la couche isolante 26 peut être réalisée avant la formation de la coque 30.
(10) Formation de l'électrode 30, par exemple par dépôt conforme.
(11) Formation de la couche conductrice 32 par exemple par dépôt physique en phase vapeur (PVD, acronyme anglais pour Physical Vapor Déposition) sur l'ensemble de la structure obtenue à l'étape (10) ou par exemple par évaporation ou par pulvérisation cathodique et gravure de cette couche pour exposer chaque fil 20.
(12) Formation de la couche d'encapsulation 34. Lorsque la couche d'encapsulation 34 est en silicone, la couche d'encapsulation 34 peut être déposée par un procédé de dépôt à la tournette, par un procédé d'impression par jet ou par un procédé de sérigraphie. Lorsque la couche d'encapsulation 34 est un oxyde, elle peut être déposée par CVD.
(13) Formation des plots conducteurs 36, 38.

Dans le mode de réalisation décrit précédemment, la couche isolante 26 ne recouvre pas le pourtour de la portion supérieure 24 de chaque fil 20. A titre de variante, la couche isolante 26 peut recouvrir une partie de la portion supérieure 24 de chaque fil 20. Dans ce cas, la couche isolante 26 recouvre le fil 20 sur une hauteur supérieure à H₂ et la coque 30 recouvre le fil 20 sur une hauteur inférieure à H₃.

Selon une autre variante, la couche isolante 26 peut, pour chaque fil 20, recouvrir partiellement la partie inférieure de la coque 30.

Selon une variante du procédé de fabrication décrit précédemment, les couches composant la coque 30 peuvent être formées avant la couche isolante 26 sur la totalité de chaque fil 20 ou seulement sur une partie du fil 20, par exemple la partie supérieure 24.

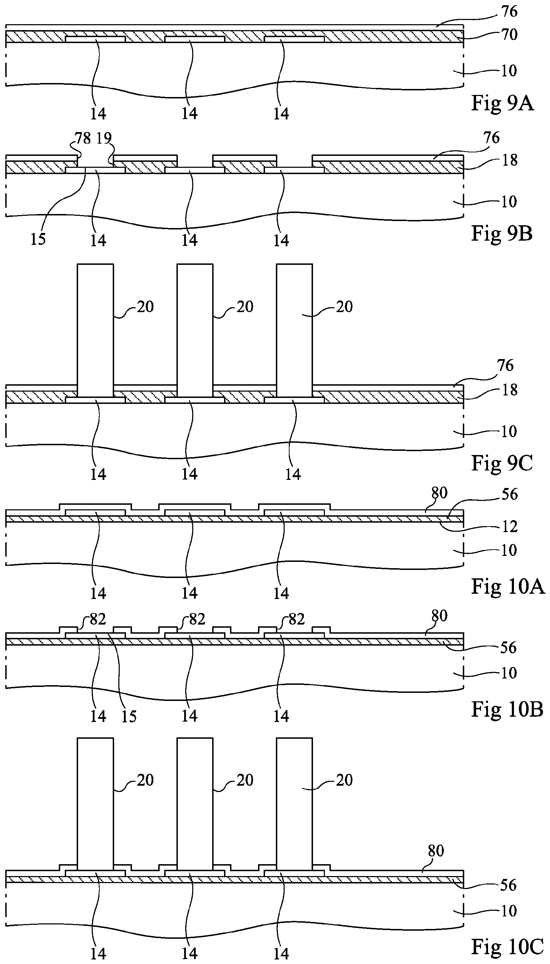

Les figures 9A à 9C illustrent des étapes d'un mode de réalisation d'un procédé de fabrication du dispositif optoélectronique 40 représenté en figure 2.

La figure 9A représente la structure obtenue après les étapes suivantes :
(1)' Formation des plots de germination 14, par exemple de façon analogue à l'étape (1) décrite précédemment.
(2)' Dépôt sur la totalité de la structure obtenue à l'étape précédente de la couche conductrice continue 70 par exemple de façon analogue à l'étape (2) décrite précédemment.
(3)' Dépôt sur la totalité de la structure obtenue à l'étape précédente d'une couche isolante continue 76, par exemple de façon analogue à ce qui a été décrit précédemment à l'étape (4) .
   La figure 9B représente la structure obtenue après les étapes suivantes :
(4)' Gravure d'ouvertures 78 dans la couche isolante 76, par exemple de façon analogue à ce qui a été décrit précédemment à l'étape (5).
(5)' Gravure des ouvertures 19 dans la couche conductrice continue 70 dans le prolongement des ouvertures 78 pour exposer une partie de la paroi supérieure 15 de chaque plot de germination 14. La gravure de la couche conductrice continue peut être réalisée, par exemple, de façon analogue à ce qui a été décrit précédemment à l'étape (3).

A titre d'exemple, les étapes (4)' et (5)' peuvent être réalisées lors d'une même étape technologique en adaptant les espèces gravantes.

La figure 9C représente la structure obtenue après la croissance des fils 20 qui peut être réalisée selon les étapes (6) et (7) décrites précédemment.

Le mode de réalisation du procédé de fabrication décrit précédemment en relation avec les figures 9A à 9C présente l'avantage que le même masque peut servir pour réaliser les ouvertures 19 dans la couche conductrice 18 et les ouvertures 78 dans la couche 76. De ce fait, par rapport au procédé de fabrication décrit précédemment en relation avec les figures 8A à 8D, un masque de moins est utilisé pour les opérations de photolithographie.

Pour la fabrication du dispositif optoélectronique 45 représenté en figure 3, un mode de réalisation d'un procédé de fabrication peut comprendre avant la formation des plots de germination 14, une étape de formation d'une couche isolante sur la totalité de la face 12 du substrat 10 et la gravure d'ouvertures dans cette couche isolante pour exposer des parties de la face 12 aux emplacements des plots de germination 14.

A titre d'exemple, le plot de germination 14 peut déborder par-dessus la couche isolante 46, c'est-à-dire que la face inférieure 17 du plot de germination 14 peut venir partiellement en contact avec la face supérieure de la couche isolante 46.

Pour la fabrication du dispositif optoélectronique 50 représenté en figure 4, un mode de réalisation d'un procédé de fabrication peut comprendre, avant ou après la formation des plots de germination 14, une étape de formation des tranchées isolantes 52. Un avantage d'un tel procédé est que les tranchées isolantes 52 peuvent être fabriquées de façon simultanée à d'autres tranchées isolantes déjà prévues sur le dispositif optoélectronique. Le procédé de fabrication n'ajoute alors pas d'étapes supplémentaires.

A titre d'exemple, dans le cas où les tranchées isolantes 52 sont fabriquées avant la formation des plots de germination 14, au moins l'un des plots de germination 14 peut déborder par-dessus l'une des tranchées d'isolation 52 adjacentes, c'est-à-dire, la face inférieure 17 du plot de germination 14 peut venir partiellement en contact avec la face supérieure de la tranchée d'isolation 72 adjacente.

Les figures 10A à 10C illustrent des étapes d'un mode de réalisation d'un procédé de fabrication du dispositif optoélectronique 55 représenté en figure 5.

La figure 10A représente la structure obtenue après les étapes suivantes :
(1)" Dépôt sur la totalité de la face 12 du substrat 10 de la couche conductrice 56, par exemple de façon analogue à l'étape (2) décrite précédemment.
(2)" Formation des plots de germination 14 sur la couche conductrice 56, par exemple de façon analogue à l'étape (1) décrite précédemment.
(3)" Dépôt sur la totalité de la structure obtenue à l'étape précédente d'une couche isolante continue 80, par exemple de façon analogue à l'étape (4) décrite précédemment.
   La figure 10B représente la structure obtenue après les étapes suivantes :
(4)" Gravure d'ouvertures 82 dans la couche isolante 80 pour exposer une partie de la paroi supérieure 15 de chaque plot de germination 14. La gravure des ouvertures 72 peut être de façon analogue à l'étape (5) décrite précédemment.

A titre de variante, la couche isolante 80 peut être remplacée par une étape de nitruration de la face supérieure des parties de la couche conductrice 56 non recouvertes par les plots 14.

La figure 10C représente la structure obtenue après la croissance des fils 20 qui peut être réalisée selon les étapes (6) et (7) décrites précédemment.

Pour la fabrication du dispositif optoélectronique 60 représenté en figure 6, un mode de réalisation d'un procédé de fabrication peut comprendre avant la formation des plots de germination 14, une étape d'implantation de dopants dans le substrat 10 pour former la région dopée 62. A titre de variante, la région 62 peut être formée, notamment par implantation, après les fils 20.

Divers modes de réalisation avec diverses variantes ont été décrits ci-dessus. On note que l'homme de l'art peut combiner divers éléments de ces divers modes de réalisation et variantes sans faire preuve d'activité inventive. A titre d'exemple, la région semiconductrice 62 décrite précédemment en relation avec la figure 6 pour le dispositif optoélectronique 60 comprenant, en outre, la couche conductrice perforée 18 peut être prévue avec le dispositif optoélectronique 55, décrit précédemment en relation avec la figure 5, dans lequel la couche conductrice 56 est continue.

## Revendications

1. Dispositif optoélectronique (5 ; 40 ; 45 ; 50 ; 55 ; 60) comprenant :
un support (10) comprenant une première face (12) ;
un premier ensemble (A) de premières diodes électroluminescentes (DEL), chaque première diode électroluminescente comprenant un premier élément semiconducteur (20) filaire, conique ou tronconique, en un premier matériau, recouvert d'une coque (28) comprenant une couche active adaptée à émettre la majorité du rayonnement fourni par la première diode électroluminescente et reposant sur une deuxième face (15) d'un premier plot (14) en un deuxième matériau différent du premier matériau et favorisant la croissance des éléments semiconducteurs, chaque premier plot comportant, en outre, une troisième face (17) opposée à la deuxième face ; et
une première couche conductrice (18 ; 56) reliant les premiers plots et s'étendant au moins sur une partie de la deuxième face ou de la troisième face de chaque premier plot, la première couche conductrice et/ou les premiers plots reposant sur le support ;
une couche isolante (26) s'étendant sur la première couche conductrice (18) ; et
une première électrode (30 ; 30₁) recouvrant chaque coque et s'étendant, en outre, sur la couche isolante ;
dans lequel les premiers plots (14) reposent sur le support (10) et dans lequel la première couche conductrice (18) s'étend sur le support (10) entre les premiers plots et recouvre une partie de la deuxième face (15) de chaque premier plot, la première couche conductrice étant ouverte aux emplacements de chaque premier élément semiconducteur (20) ou dans lequel la première couche conductrice (56) repose sur la première face (12) et dans lequel chaque premier plot (14) repose sur la première couche conductrice du côté de la troisième face (17).

2. Dispositif optoélectronique selon la revendication 1, dans lequel la première couche conductrice (18 ; 56) est en un matériau choisi parmi le groupe comprenant les alliages comprenant un métal de transition ou plus d'un métal de transition parmi W, Ta, Re, Os, Mo, Nb, Pt, Pd, Cr, Zr, Hf, Cu, Co, Ni et Ti et leurs formes siliciurées, nitrurées et carburées.

3. Dispositif optoélectronique selon la revendication 1 ou 2, dans lequel la première couche conductrice (18 ; 56) est en un matériau choisi parmi le groupe comprenant les siliciures et les métaux adaptés à former un siliciure, notamment Pt, PtSi, Ti, TiSi₂, Co, CoSi₂, CoSi, Co₂Si, Ni, NiSi, NiSi₂, W, WSi₂, Mo, MoSi₂, Ta et TaSi₂.

4. Dispositif optoélectronique selon l'une quelconque des revendications 1 à 3, dans lequel la première couche conductrice (18 ; 56) est en un matériau choisi parmi le groupe comprenant les siliciures et les métaux adaptés à former un siliciure stable sur du silicium à une température de 1000°C, notamment W, WSi₂, Mo, MoSi₂, Ta et TaSi₂, Ti, TiSi₂, Co, CoSi₂, TiW et TiWSi.

5. Dispositif optoélectronique selon l'une quelconque des revendications 1 à 4, dans lequel la première couche conductrice (18 ; 56) est en un matériau choisi parmi les matériaux présentant un coefficient de dilatation thermique proche, à 10 % près, du coefficient de dilatation thermique du silicium ou du silicium polycristallin, notamment W, WSi₂, TiW, TiWSi₂.

6. Dispositif optoélectronique selon l'une quelconque des revendications 1 à 5, dans lequel les premiers plots (14) reposent sur le support (10) et dans lequel la première couche conductrice (18) s'étend sur le support (10) entre les premiers plots et recouvre une partie de la deuxième face (15) de chaque premier plot, la première couche conductrice étant ouverte aux emplacements de chaque premier élément semiconducteur (20).

7. Dispositif optoélectronique selon la revendication 6, dans lequel la couche isolante (26) s'étend entre les premiers éléments semiconducteurs (20) et la première couche conductrice (18) .

8. Dispositif optoélectronique selon la revendication 6, dans lequel la première couche conductrice (18) est au contact des premiers éléments semiconducteurs (20).

9. Dispositif optoélectronique selon l'une quelconque des revendications 1 à 8, dans lequel le support comprend un substrat (10) semiconducteur et une région isolante (46) entre le substrat et la première couche conductrice (18).

10. Dispositif optoélectronique selon l'une quelconque des revendications 1 à 5, dans lequel la première couche conductrice (56) repose sur la première face (12) et dans lequel chaque premier plot (14) repose sur la première couche conductrice du côté de la troisième face (17).

11. Dispositif optoélectronique selon la revendication 10, dans lequel la couche isolante (26) recouvre en outre une partie de chaque premier plot (14).

12. Dispositif optoélectronique selon la revendication 10, dans lequel la partie de la première couche conductrice (56) non recouverte par les premiers plots (14) est nitrurée en surface.

13. Dispositif optoélectronique selon l'une quelconque des revendications 1 à 12, dans lequel chaque premier plot (14) est en un matériau choisi parmi le groupe comprenant un nitrure, un carbure ou un borure d'un métal de transition de la colonne IV, V ou VI du tableau périodique des éléments ou une combinaison de ces composés.

14. Dispositif optoélectronique selon l'une quelconque des revendications 1 à 13, dans lequel le support est un substrat (10) semiconducteur non dopé ou dopé avec une concentration de dopants inférieure ou égale à 5^{∗}10¹⁶ atomes/cm³, le dispositif comprenant, en outre, une région semiconductrice (62) dopée s'étendant dans le substrat (10) depuis la première face (12) avec une concentration de dopants comprise entre 5^{∗}10¹⁶ atomes/cm³ et 2^{∗}10²⁰ atomes/cm³, ladite région étant au contact de la première couche conductrice (18).

15. Dispositif optoélectronique selon l'une quelconque des revendications 1 à 14, comprenant, en outre :
une première électrode (30₁, 32₁) reliée aux premières diodes électroluminescentes (DEL₁) ;
un deuxième ensemble (A2) de deuxièmes diodes électroluminescentes (DEL₂) comprenant des deuxièmes éléments semiconducteurs filaires, coniques ou tronconiques reposant chacun sur une quatrième face d'un deuxième plot (14₂), chaque deuxième plot comportant, en outre, une cinquième face opposée à la quatrième face ;
une deuxième couche conductrice (18₂) reliant les deuxièmes plots et s'étendant au moins sur une partie de la quatrième face ou de la cinquième face de chaque deuxième plot, la deuxième couche conductrice et/ou les deuxièmes plots reposant sur le support ; et
une deuxième électrode (30₂, 32₂) reliée aux deuxièmes diodes électroluminescentes (DEL₁).

16. Dispositif optoélectronique selon la revendication 15, dans lequel la deuxième électrode (30₂, 32₂) vient au contact de la première couche conductrice (18₁).

17. Procédé de fabrication d'un dispositif optoélectronique (5 ; 40 ; 45 ; 50 ; 55 ; 60) comprenant les étapes suivantes :
prévoir un support (10) comprenant une première face (12) ;
former un premier ensemble (A) de premières diodes électroluminescentes (DEL), chaque première diode électroluminescente comprenant un premier élément semiconducteur (20) filaire, conique ou tronconique, en un premier matériau, recouvert d'une coque (28) comprenant une couche active adaptée à émettre la majorité du rayonnement fourni par la première diode électroluminescente et reposant sur une deuxième face (15) d'un premier plot (14) en un deuxième matériau différent du premier matériau et favorisant la croissance des éléments semiconducteurs, chaque premier plot comportant, en outre, une troisième face (17) opposée à la deuxième face ;
former une première couche conductrice (18 ; 56) reliant les premiers plots et s'étendant au moins sur une partie de la deuxième face ou de la troisième face de chaque premier plot, la première couche conductrice et/ou les premiers plots reposant sur le support ;
former une première couche isolante (26) s'étendant sur la première couche conductrice (18) ; et
former une première électrode (30 ; 30₁) recouvrant chaque coque et s'étendant, en outre, sur la première couche isolante ;
dans lequel les premiers plots (14) reposent sur le support (10) et dans lequel la première couche conductrice (18) s'étend sur le support (10) entre les premiers plots et recouvre une partie de la deuxième face (15) de chaque premier plot, la première couche conductrice étant ouverte aux emplacements de chaque premier élément semiconducteur (20) ou dans lequel la première couche conductrice (56) repose sur la première face (12) et dans lequel chaque premier plot (14) repose sur la première couche conductrice du côté de la troisième face (17).

18. Procédé selon la revendication 17, comprenant les étapes successives suivantes :
former les premiers plots (14) sur le support (10) ;
recouvrir les premiers plots (14) et le support (10) d'une troisième couche conductrice (70) ;
former des premières ouvertures (19) dans la troisième couche conductrice pour former la première couche conductrice (18), chaque première ouverture exposant une première partie de l'un des premiers plots ;
recouvrir la troisième couche conductrice et les premières parties exposées d'une deuxième couche isolante (72) ;
former des deuxièmes ouvertures (74) dans la deuxième couche isolante, chaque deuxième ouverture exposant une deuxième partie de l'un des premiers plots ; et
faire croître les premiers éléments semiconducteurs (20) depuis les deuxièmes parties exposées des premiers plots.

19. Procédé selon la revendication 17, comprenant les étapes successives suivantes :
former les premiers plots (14) sur le support (10) ;
recouvrir les premiers plots (14) et le support (10) d'une quatrième couche conductrice (70) ;
recouvrir la quatrième couche conductrice d'une troisième couche isolante (76) ;
former des troisièmes ouvertures (78) dans la troisième couche isolante et des quatrièmes ouvertures (19), prolongeant les troisièmes ouvertures, dans la quatrième couche conductrice, pour former la première couche conductrice (18), chaque quatrième ouverture exposant une troisième partie de l'un des premiers plots ; et
faire croître les premiers éléments semiconducteurs (20) depuis les troisièmes parties exposées des premiers plots.

20. Procédé selon la revendication 17, comprenant les étapes successives suivantes :
recouvrir le support (10) d'une cinquième couche conductrice (56) ;
former les premiers plots (14) sur la cinquième couche conductrice ;
recouvrir la cinquième couche conductrice et les premiers plots d'une quatrième couche isolante (80) ;
former des cinquièmes ouvertures (82) dans la quatrième couche isolante, chaque cinquième ouverture exposant une quatrième partie de l'un des premiers plots ; et
faire croître les premiers éléments semiconducteurs (20) depuis les quatrièmes parties exposées des premiers plots.

## Patentansprüche

1. Optoelektronische Vorrichtung (5; 40; 45; 50; 55; 60), die folgendes aufweist:
einen Träger (10) mit einer ersten Oberfläche (12);
eine erste Anordnung (A) von ersten lichtemittierenden Dioden (DEL), wobei jede erste lichtemittierende Diode ein erstes drahtförmiges, konisches oder kegelstumpfförmiges Halbleiterelement (20) aus einem ersten Material aufweist, das von einer Hülle (28) bedeckt ist, die eine aktive Schicht aufweist, die geeignet ist, den größten Teil der von der ersten lichtemittierenden Diode gelieferten Strahlung zu emittieren, und die auf einer zweiten Oberfläche (15) eines ersten Pads (14) aufliegt, das aus einem zweiten Material hergestellt ist, das sich vom ersten Material unterscheidet und das Wachstum der Halbleiterelemente begünstigt, wobei jedes erste Pad ferner eine dritte Oberfläche (17) entgegengesetzt der zweiten Oberfläche aufweist; und
eine erste leitende Schicht (18; 56), die erste Pads verbindet und sich wenigstens über einen Teil der zweiten Oberfläche oder der dritten Oberfläche jedes ersten Pads erstreckt, wobei die erste leitende Schicht und/oder die ersten Pads auf dem Träger aufliegen;
eine Isolierschicht (26), die sich auf der ersten leitenden Schicht (18) erstreckt; und
eine erste Elektrode (30, 30₁), die jede Hülle bedeckt und sich weiter auf der Isolierschicht erstreckt;
wobei die ersten Pads (14) auf dem Träger (10) aufliegen und wobei sich die erste leitende Schicht (18) auf dem Träger (10) zwischen den ersten Pads erstreckt und einen Teil der zweiten Oberfläche (15) jedes ersten Pads bedeckt, wobei die erste leitende Schicht an den Positionen jedes ersten Halbleiterelements (20) offen ist oder wobei die erste leitende Schicht (56) auf der ersten Oberfläche (12) aufliegt und wobei jedes erste Pad (14) auf der ersten leitenden Schicht auf der Seite der dritten Oberfläche (17) aufliegt.

2. Optoelektronische Vorrichtung nach Anspruch 1, wobei die erste leitende Schicht (18; 56) aus einem Material hergestellt ist, das aus der Gruppe ausgewählt ist, die Legierungen aufweist, die ein Übergangsmetall oder mehr als ein Übergangsmetall aus W, Ta, Re, Os, Mo, Nb, Pt, Pd, Cr, Zr, Hf, Cu, Co, Ni und Ti und deren silizidierte, nitrierte und karbonierte Formen aufweisen.

3. Optoelektronische Vorrichtung nach Anspruch 1 oder 2, wobei die erste leitende Schicht (18; 56) aus einem Material hergestellt ist, das aus der Gruppe ausgewählt ist, die Silizide und Metalle aufweist, die geeignet sind, ein Silizid auszubilden, insbesondere Pt, PtSi, Ti, TiSi₂, Co, CoSi₂, CoSi, Co₂Si, Ni, NiSi, NiSi₂, W, WSi₂, Mo, MoSi₂, Ta und TaSi₂.

4. Optoelektronische Vorrichtung nach einem der Ansprüche 1 bis 3, wobei die erste leitende Schicht (18; 56) aus einem Material hergestellt ist, das aus der Gruppe ausgewählt ist, die Silizide und Metalle aufweist, die bei einer Temperatur von 1000°C ein stabiles Silizid auf Silizium ausbilden können, insbesondere W, WSi₂, Mo, MoSi₂, Ta und TaSi₂, Ti, TiSi₂, Co, CoSi₂, TiW und TiWSi.

5. Optoelektronische Vorrichtung nach einem der Ansprüche 1 bis 4, wobei die erste leitende Schicht (18; 56) aus einem Material hergestellt ist, das ausgewählt ist aus Materialien mit einem Wärmeausdehnungskoeffizienten, der dem Wärmeausdehnungskoeffizienten von Silizium oder Polysilizium innerhalb von 10% entspricht, insbesondere W, WSi₂, TiW, TiWSi₂.

6. Optoelektronische Vorrichtung nach einem der Ansprüche 1 bis 5, wobei die ersten Pads (14) auf dem Träger (10) aufliegen und wobei sich die erste leitende Schicht (18) auf dem Träger (10) zwischen den ersten Pads erstreckt und einen Teil der zweiten Oberfläche (15) jedes ersten Pads bedeckt, wobei die erste leitende Schicht an den Positionen jedes ersten Halbleiterelements (20) offen ist.

7. Optoelektronische Vorrichtung nach Anspruch 6, wobei sich die Isolierschicht (26) zwischen den ersten Halbleiterelementen (20) und der ersten leitenden Schicht (18) erstreckt.

8. Optoelektronische Vorrichtung nach Anspruch 6, wobei die erste leitende Schicht (18) in Kontakt mit den ersten Halbleiterelementen (20) ist.

9. Optoelektronische Vorrichtung nach einem der Ansprüche 1 bis 8, wobei der Träger ein Halbleitersubstrat (10) und einen Isolationsbereich (46) zwischen dem Substrat und der ersten leitenden Schicht (18) aufweist.

10. Optoelektronische Vorrichtung nach einem der Ansprüche 1 bis 5, wobei die erste leitende Schicht (56) auf der ersten Oberfläche (12) aufliegt und wobei jedes erste Pad (14) auf der ersten leitenden Schicht auf der Seite der dritten Oberfläche (17) aufliegt.

11. Optoelektronische Vorrichtung nach Anspruch 10, wobei die Isolierschicht (26) weiterhin einen Teil jedes ersten Pads (14) abdeckt.

12. Optoelektronische Vorrichtung nach Anspruch 10, wobei der Teil der ersten leitenden Schicht (56), der nicht mit den ersten Pads (14) bedeckt ist, an seiner Oberfläche nitriert ist.

13. Optoelektronische Vorrichtung nach einem der Ansprüche 1 bis 12, wobei jedes erste Pad (14) aus einem Material hergestellt ist, das aus der Gruppe ausgewählt ist, die ein Nitrid, ein Carbid oder ein Borid eines Übergangsmetalls aus den Spalten IV, V oder VI des Periodensystems der Elemente oder einer Kombination dieser Verbindungen aufweist.

14. Optoelektronische Vorrichtung nach einem der Ansprüche 1 bis 13, wobei der Träger ein dotiertes oder undotiertes Halbleitersubstrat (10) mit einer Dotierungskonzentration kleiner oder gleich 5^{∗}10¹⁶ Atomen/cm³ ist, wobei die Vorrichtung ferner einen dotierten Halbleiterbereich (62) aufweist, der sich in dem Substrat (10) von der ersten Oberfläche (12) mit einer Dotierungskonzentration im Bereich von 5^{∗}10¹⁶ Atomen/cm³ bis 2^{∗}10²⁰ Atomen/cm³ erstreckt, wobei der Bereich in Kontakt mit der ersten leitenden Schicht (18) ist.

15. Optoelektronische Vorrichtung nach einem der Ansprüche 1 bis 14, die ferner folgendes aufweist:
eine erste Elektrode (30₁, 32₁), die mit den ersten lichtemittierenden Dioden (DEL₁) verbunden ist;
eine zweite Anordnung (A2) von zweiten lichtemittierenden Dioden (DEL₂), die zweite drahtförmige, konische oder kegelstumpfförmige Halbleiterelemente aufweist, die jeweils auf einer vierten Oberfläche eines zweiten Pads (14₂) aufliegen, wobei jedes zweite Pad ferner eine fünfte Oberfläche gegenüber der vierten Oberfläche aufweist;
eine zweite leitende Schicht (18₂), die die zweiten Pads verbindet und sich wenigstens über einen Teil der vierten Oberfläche oder der fünften Oberfläche jedes zweiten Pads erstreckt, wobei die zweite leitende Schicht und/oder die zweiten Pads auf dem Träger aufliegen; und
eine zweite Elektrode (30₂, 32₂), die mit den zweiten lichtemittierenden Dioden (DEL₁) verbunden ist.

16. Optoelektronische Vorrichtung nach Anspruch 15, wobei die zweite Elektrode (30₂, 32₂) mit der ersten leitenden Schicht (18₁) in Kontakt kommt.

17. Verfahren zur Herstellung einer optoelektronischen Vorrichtung (5; 40; 45; 50; 55; 60), das die folgenden Schritte aufweist:
Vorsehen eines Trägers (10), der eine erste Oberfläche (12) aufweist;
Ausbilden einer ersten Anordnung (A) von ersten lichtemittierenden Dioden (DEL), wobei jede erste lichtemittierende Diode ein erstes drahtförmiges, konisches oder kegelstumpfförmiges Halbleiterelement (20) aus einem ersten Material aufweist, das von einer Hülle (28) bedeckt ist, die eine aktive Schicht aufweist, die geeignet ist, um den größten Teil der von der ersten lichtemittierenden Diode gelieferten Strahlung zu emittieren, und die auf einer zweiten Oberfläche (15) eines ersten Pads (14) aufliegt, das aus einem zweiten Material hergestellt ist, das sich vom ersten Material unterscheidet und das Wachstum der Halbleiterelemente begünstigt, wobei jedes erste Pad ferner eine dritte Oberfläche (17) entgegengesetzt der zweiten Oberfläche aufweist;
Ausbilden einer ersten leitenden Schicht (18; 56), die erste Pads verbindet und sich wenigstens über einen Teil der zweiten Oberfläche oder der dritten Oberfläche jedes ersten Pads erstreckt, wobei die erste leitende Schicht und/oder die ersten Pads auf dem Träger aufliegen;
Ausbilden einer ersten Isolierschicht (26), die sich auf der ersten leitenden Schicht (18) erstreckt; und
Ausbilden einer ersten Elektrode (30, 30₁), die jede Hülle bedeckt und sich weiter auf der ersten Isolierschicht erstreckt;
wobei die ersten Pads (14) auf dem Träger (10) aufliegen und wobei sich die erste leitende Schicht (18) auf dem Träger (10) zwischen den ersten Pads erstreckt und einen Teil der zweiten Oberfläche (15) jedes ersten Pads bedeckt, wobei die erste leitende Schicht an den Positionen jedes ersten Halbleiterelements (20) offen ist oder wobei die erste leitende Schicht (56) auf der ersten Oberfläche (12) aufliegt und wobei jedes erste Pad (14) auf der ersten leitenden Schicht auf der Seite der dritten Oberfläche (17) aufliegt.

18. Verfahren nach Anspruch 17, das die folgenden aufeinanderfolgenden Schritte aufweist:
Ausbilden der ersten Pads (14) auf dem Träger (10);
Abdecken der ersten Pads (14) und des Trägers (10) mit einer dritten leitenden Schicht (70);
Ausbilden erster Öffnungen (19) in der dritten leitenden Schicht, um die erste leitende Schicht (18) auszubilden, wobei jede erste Öffnung einen ersten Teil eines der ersten Pads freilegt;
Abdecken der dritten leitenden Schicht und der ersten freiliegenden Teile mit einer zweiten Isolierschicht (72);
Ausbilden zweiter Öffnungen (74) in der zweiten Isolierschicht, wobei jede zweite Öffnung einen zweiten Teil eines der ersten Pads freilegt; und
Wachsen der ersten Halbleiterelemente (20) aus den zweiten freiliegenden Teilen der ersten Pads.

19. Verfahren nach Anspruch 17, das die folgenden aufeinanderfolgenden Schritte aufweist:
Ausbilden der ersten Pads (14) auf dem Träger (10);
Abdecken der ersten Pads (14) und des Trägers (10) mit einer vierten leitenden Schicht (70);
Abdecken der vierten leitenden Schicht mit einer dritten Isolierschicht (76);
Ausbilden von dritten Öffnungen (78) in der dritten Isolierschicht und vierten Öffnungen (19), welche die dritten Öffnungen in der vierten leitenden Schicht fortsetzen, um die erste leitende Schicht (18) auszubilden, wobei jede vierte Öffnung einen dritten Teil eines der ersten Pads freilegt; und
Wachsen der ersten Halbleiterelemente (20) aus den dritten freiliegenden Teilen der ersten Pads.

20. Verfahren nach Anspruch 17, das die folgenden aufeinanderfolgenden Schritte aufweist:
Abdecken des Trägers (10) mit einer fünften leitenden Schicht (56);
Ausbilden der ersten Pads (14) auf der fünften leitenden Schicht;
Abdecken der fünften leitenden Schicht und der ersten Pads mit einer vierten Isolierschicht (80);
Ausbilden von fünften Öffnungen (82) in der vierten Isolierschicht, wobei jede fünfte Öffnung einen vierten Teil eines der ersten Pads freilegt; und
Wachsen der ersten Halbleiterelemente (20) aus den vierten freiliegenden Teilen der ersten Pads.

## Claims

1. An optoelectronic device (5; 40; 45; 50; 55; 60) comprising:
a support (10) having a first surface (12);
a first assembly (A) of first light-emitting diodes (DEL), each first light-emitting diode comprising a first wire-shaped, conical or frustoconical semiconductor element (20), made of a first material, covered by a shell (28) comprising an active layer adapted to emit most of the radiation delivered by the first light-emitting diode and resting on a second surface (15) of a first pad (14) made of a second material different from the first material and favoring the growth of the semiconductor elements, each first pad further comprising a third surface (17) opposite to the second surface; and
a first conductive layer (18; 56) connecting first pads and extending at least over a portion of the second surface or of the third surface of each first pad, the first conductive layer and/or the first pads resting on the support;
an insulating layer (26) extending on the first conductive layer (18); and
a first electrode (30, 30₁) covering each shell and further extending on the insulating layer;
wherein the first pads (14) rest on the support (10) and wherein the first conductive layer (18) extends on the support (10) between the first pads and covers a portion of the second surface (15) of each first pad, the first conductive layer being open at the locations of each first semiconductor element (20) or wherein the first conductive layer (56) rests on the first surface (12) and wherein each first pad (14) rests on the first conductive layer on the side of the third surface (17).

2. The optoelectronic device of claim 1, wherein the first conductive layer (18; 56) is made of a material selected from the group comprising alloys comprising a transition metal or more than one transition metal from among W, Ta, Re, Os, Mo, Nb, Pt, Pd, Cr, Zr, Hf, Cu, Co, Ni, and Ti and their silicided, nitrided, and carbided forms.

3. The optoelectronic device of claim 1 or 2, wherein the first conductive layer (18; 56) is made of a material selected from the group comprising silicides and metals capable of forming a silicide, particularly Pt, PtSi, Ti, TiSi₂, Co, CoSi₂, CoSi, Co₂Si, Ni, NiSi, NiSi₂, W, WSi₂, Mo, MoSi₂, Ta, and TaSi₂.

4. The optoelectronic device of any of claims 1 to 3, wherein the first conductive layer (18; 56) is made of a material selected from the group comprising silicides and metals capable of forming a stable silicide on silicon at a 1,000°C temperature, particularly W, WSi₂, Mo, MoSi₂, Ta and TaSi₂, Ti, TiSi₂, Co, CoSi₂, TiW, and TiWSi.

5. The optoelectronic device of any of claims 1 to 4, wherein first conductive layer (18; 56) is made of a material selected from among materials having a thermal expansion coefficient close, to within 10%, to the thermal expansion coefficient of silicon or of polysilicon, particularly W, WSi₂, TiW, TiWSi₂.

6. The optoelectronic device of any of claims 1 to 5, wherein the first pads (14) rest on the support (10) and wherein the first conductive layer (18) extends on the support (10) between the first pads and covers a portion of the second surface (15) of each first pad, the first conductive layer being open at the locations of each first semiconductor element (20).

7. The optoelectronic device of claim 6, wherein the insulating layer (26) extends between the first semiconductor elements (20) and the first conductive layer (18).

8. The optoelectronic device of claim 6, wherein the first conductive layer (18) is in contact with the first semiconductor elements (20).

9. The optoelectronic device of any of claims 1 to 8, wherein the support comprises a semiconductor substrate (10) and an insulating region (46) between the substrate and the first conductive layer (18).

10. The optoelectronic device of any of claims 1 to 5, wherein the first conductive layer (56) rests on the first surface (12) and wherein each first pad (14) rests on the first conductive layer on the side of the third surface (17).

11. The optoelectronic device of claim 10, wherein the insulating layer (26) further covers a portion of each first pad (14) .

12. The optoelectronic device of claim 10, wherein the portion of the first conductive layer (56) which is not covered with the first pads (14) is nitrided at its surface.

13. The optoelectronic device of any of claims 1 to 12, wherein each first pad (14) is made of material selected from the group comprising a nitride, a carbide, or a boride of a transition metal from column IV, V, or VI of the periodic table of elements or a combination of these compounds.

14. The optoelectronic device of any of claims 1 to 13, wherein the support is a doped or undoped semiconductor substrate (10), with a dopant concentration smaller than or equal to 5^{∗}10¹⁶ atoms/cm³, the device further comprising a doped semiconductor region (62) extending in the substrate (10) from the first surface (12) with a dopant concentration in the range from 5^{∗}10¹⁶ atoms/cm³ to 2^{∗}10²⁰ atoms/cm³, said region being in contact with the first conductive layer (18).

15. The optoelectronic device of any of claims 1 to 14, further comprising:
a first electrode (30₁, 32₁) connected to the first light-emitting diodes (DEL₁);
a second assembly (A2) of second light-emitting diodes (DEL₂) comprising second wire-shaped, conical, or frustoconical semiconductor elements, each resting on a fourth surface of a second pad (14₂), each second pad further comprising a fifth surface opposite to the fourth surface;
a second conductive layer (18₂) connecting the second pads and extending at least over a portion of the fourth surface or of the fifth surface of each second pad, the second conductive layer and/or the second pads resting on the support; and
a second electrode (30₂, 32₂) connected to the second light-emitting diodes (DEL₁).

16. The optoelectronic device of claim 15, wherein the second electrode (30₂, 32₂) comes into contact with the first conductive layer (18₁).

17. A method of manufacturing an optoelectronic device (5; 40; 45; 50; 55; 60) comprising the steps of:
providing a support (10) comprising a first surface (12) ;
forming a first assembly (A) of first light-emitting diodes (DEL), each first light-emitting diode comprising a first wire-shaped, conical, or frustoconical semiconductor element (20), made of a first material, covered by a shell (28) comprising an active layer adapted to emit most of the radiation delivered by the first light-emitting diode and resting on a second surface (15) of a first pad (14) made of a second material different from the first material and favoring the growth of the semiconductor elements, each first pad further comprising a third surface (17) opposite to the second surface;
forming a first conductive layer (18; 56) connecting first pads and extending at least over a portion of the second surface or of the third surface of each first pad, the first conductive layer and/or the first pads resting on the support;
forming a first insulating layer (26) extending on the first conductive layer (18); and
forming a first electrode (30, 30₁) covering each shell and further extending on the first insulating layer;
wherein the first pads (14) rest on the support (10) and wherein the first conductive layer (18) extends on the support (10) between the first pads and covers a portion of the second surface (15) of each first pad, the first conductive layer being open at the locations of each first semiconductor element (20) or wherein the first conductive layer (56) rests on the first surface (12) and wherein each first pad (14) rests on the first conductive layer on the side of the third surface (17).

18. The method of claim 17, comprising the successive steps of:
forming the first pads (14) on the support (10);
covering the first pads (14) and the support (10) with a third conductive layer (70);
forming first openings (19) in the third conductive layer to form the first conductive layer (18), each first opening exposing a first portion of one of the first pads;
covering the third conductive layer and the first exposed portions with a second insulating layer (72);
forming second openings (74) in the second insulating layer, each second opening exposing a second portion of one of the first pads; and
growing the first semiconductor elements (20) from the second exposed portions of the first pads.

19. The method of claim 17, comprising the successive steps of:
forming the first pads (14) on the support (10);
covering the first pads (14) and the support (10) with a fourth conductive layer (70);
covering the fourth conductive layer with a third insulating layer (76);
forming third openings (78) in the third insulating layer and fourth openings (19), continuing the third openings, in the fourth conductive layer, to form the first conductive layer (18), each fourth opening exposing a third portion of one of the first pads; and
growing the first semiconductor elements (20) from the third exposed portions of the first pads.

20. The method of claim 17, comprising the successive steps of:
covering the support (10) with a fifth conductive layer (56) ;
forming the first pads (14) on the fifth conductive layer;
covering the fifth conductive layer and the first pads with a fourth insulating layer (80);
forming fifth openings (82) in the fourth insulating layer, each fifth opening exposing a fourth portion of one of the first pads; and
growing the first semiconductor elements (20) from the fourth exposed portions of the first pads.
